# FASCICULE DE BREVET EUROPEEN

(11) **EP 4 034 894 B1**
(45) Date de publication et mention de la délivrance du brevet: **28.08.2024**
(21) Numéro de dépôt: 20820252.3
(22) Date de dépôt: 16.09.2020
(51) Int. Cl.: G01R 29/08, G01J 4/04, H01Q 1/38, H01Q 15/22, H01Q 15/24

(54) **DISPOSITIF POUR REVELER DES VARIATIONS SPATIALES DE POLARISATION D'UN RAYONNEMENT ELECTROMAGNETIQUE**
VORRICHTUNG ZUR ERKENNUNG VON RÄUMLICHEN VERÄNDERUNGEN DER POLARISATION ELEKTROMAGNETISCHER STRAHLUNG
DEVICE FOR REVEALING SPATIAL VARIATIONS IN THE POLARISATION OF ELECTROMAGNETIC RADIATION

(30) Priorité: 24.09.2019 FR 1910495
(43) Date de publication de la demande: 03.08.2022
(73) Titulaire: Office National d'Etudes et de Recherches Aérospatiales, 91120 Palaiseau (FR); Centre National d'Etudes Spatiales, 75001 Paris (FR); UNIVERSITE TOULOUSE III - PAUL SABATIER, 31062 Toulouse Cedex 9 (FR); CENTRE NATIONAL DE LA RECHERCHE SCIENTIFIQUE (CNRS), 75016 Paris (FR)
(72) Inventeur: PROST, Daniel, 31000 Toulouse (FR); ROMIER, Maxime, 31270 Cugnaux (FR); BELOT, Daniel, 31490 Leguevin (FR); SIMON, Patrice, 31500 Toulouse (FR); BROUSSE, Kévin, 31062 Toulouse (FR); TABERNA, Pierre-Louis, 31062 Toulouse (FR)
(74) Mandataire: Hautier IP
(86) Numéro de dépôt international: PCT/FR2020/051601
(87) Numéro de publication internationale: WO 2021/058895

(56) Documents cités:
- FR-A1- 2 959 355
- US-A1- 2019 242 755
- STÉPHANE FAURE ET AL: "Electromagnetic Field Intensity Imaging by Thermofluorescence in the Visible Range", PHYSICAL REVIEW APPLIED, vol. 11, no. 5, 1 May 2019 (2019-05-01), XP055700210, ISSN: 2331-7019, DOI: 10.1103/PhysRevApplied.11.054084
- RAGAZZO HUGO ET AL: "Thermo-fluorescent images of electric and magnetic near-fields of a High Impedance Surface", 2019 INTERNATIONAL SYMPOSIUM ON ELECTROMAGNETIC COMPATIBILITY - EMC EUROPE, IEEE, 2 September 2019 (2019-09-02), pages 257 - 260, XP033633743, DOI: 10.1109/EMCEUROPE.2019.8871884
- NORGARD J D ED - DRIGGERS RONALD G: "INFRARED/MICROWAVE CORRELATION MEASUREMENTS", OPTICAL ENGINEERING, SOC. OF PHOTO-OPTICAL INSTRUMENTATION ENGINEERS, BELLINGHAM, vol. 33, no. 1, 1 January 1994 (1994-01-01), pages 85 - 96, XP000421271, ISSN: 0091-3286, DOI: 10.1117/12.155377

## Description

### Domaine technique

La présente description concerne un dispositif pour révéler des variations spatiales de polarisation d'un rayonnement électromagnétique, ainsi qu'un procédé de fabrication d'un tel dispositif.

### Technique antérieure

Il est parfois utile de caractériser un rayonnement électromagnétique, notamment dans le domaine spectral dit hyperfréquence, non seulement par son intensité, mais aussi par l'orientation vectorielle de son champ électrique, ou de son champ magnétique. De façon connue, l'orientation vectorielle du champ électrique, ou du champ magnétique, d'un rayonnement correspond à sa polarisation. Celle-ci peut être rectiligne, circulaire ou elliptique, en fonction des amplitudes respectives de deux composantes du champ selon des vecteurs fixes, et du déphasage qui existe entre ces deux composantes. De façon connue, les cas de polarisations rectilignes et circulaires sont des cas particuliers des polarisations elliptiques, qui ne sont pas nécessairement réalisés de façon stricte.

Le document FR 2 787 583 décrit d'utiliser un support bidimensionnel qui est transparent ou sensiblement transparent au rayonnement électromagnétique à caractériser, et qui comporte sur l'une de ses surfaces un réseau périodique de bandes parallèles d'un matériau photothermique. Ce matériau photothermique est le siège d'un échauffement sous l'effet du rayonnement électromagnétique, soit par effet Joule, soit par un mécanisme de pertes diélectriques, soit par un mécanisme de pertes magnétiques. Mais grâce à la répartition du matériau photothermique en bandes parallèles sur le support bidimensionnel, sa capacité d'échauffement est anisotrope en fonction de la direction du champ électrique ou magnétique auquel le matériau est sensible : pour un rayonnement électromagnétique qui est polarisé rectilignement, cet échauffement est maximal lorsque la direction de polarisation rectiligne du champ auquel est sensible le matériau photothermique est parallèle aux bandes. L'échauffement du matériau photothermique est révélé par thermographie, par exemple en utilisant un capteur d'image infrarouge sur lequel est formée une image du support bidimensionnel muni des bandes du matériau photothermique. Toutefois, le détecteur ainsi formé, qui est sensible à la direction du champ d'un rayonnement électromagnétique, ne permet pas de détecter des variations spatiales de la polarisation du rayonnement électromagnétique.

Le document US 2019/0242755 A1 décrit un système pour imager thermiquement des signaux radiofréquences, qui utilise une feuille munie d'un réseau de motifs.

Le document FR 2 959 355 A1 décrit une surface qui est munie de motifs conducteurs élémentaires identiques, périodiques et disjoints, pour filtrer plusieurs bandes de fréquences.

L'article de Stéphane Faure et al., intitulé "Electromagnetic Field Intensity Imaging by Thermofluorescence in the Visible Range", Physical Review Applied, Vol. 11, no. 5, 054084 (2019), concerne l'imagerie de champ électromagnétique microonde en utilisant la thermofluorescence.

### Problème technique

A partir de cette situation, un but de la présente invention est de proposer un nouveau détecteur sensible à la direction du champ d'un rayonnement électromagnétique, et qui permette de révéler des variations spatiales de la polarisation du rayonnement électromagnétique.

Un but annexe de l'invention est de proposer un tel détecteur dont la sensibilité soit élevée, et qui soit peu onéreux à fabriquer.

### Résumé de l'invention

Pour atteindre l'un au moins de ces buts ou un autre, un premier aspect de l'invention propose un nouveau dispositif qui est adapté pour révéler des variations spatiales de polarisation d'un rayonnement électromagnétique, sous forme de variations de température localisées. Ce dispositif est défini dans la revendication indépendante 1 et comprend une surface d'un support qui est isolante thermiquement et électriquement, et comporte, dans ou sur cette surface du support, un réseau de motifs qui sont constitués chacun d'au moins un segment rectiligne, de préférence d'au moins deux segments rectilignes, d'un matériau appelé matériau sensible. Ce matériau sensible est adapté pour produire un échauffement lorsqu'il est exposé à un champ électrique ou à un champ magnétique du rayonnement, avec une valeur d'un taux de puissance d'échauffement par rapport à une puissance du rayonnement électromagnétique qui varie en fonction d'une polarisation du rayonnement électromagnétique par rapport à une orientation de chaque segment dans la surface du support. En outre, ce taux de puissance d'échauffement par rapport à la puissance du rayonnement électromagnétique est nul ou sensiblement nul dans le support en dehors des segments du matériau sensible, quelle que soit la polarisation du rayonnement. Le matériau sensible qui est ainsi défini peut correspondre en particulier à un matériau photothermique tel que mentionné plus haut.

Selon une première caractéristique de l'invention, si chaque motif comporte plusieurs segments, ces segments ont au moins deux orientations qui sont différentes à l'intérieur de chaque motif. Alternativement, si chaque motif ne comporte qu'un seul segment, les segments de deux motifs qui sont voisins ont des orientations différentes. Autrement dit, les segments rectilignes de matériau sensible ont des orientations qui sont différentes à l'intérieur de chaque motif, ou entre des motifs séparés mais voisins. Ainsi, des segments dont les orientations sont différentes sont plus sensibles chacun à une composante de polarisation rectiligne du rayonnement qui est différente de celle pour laquelle un autre segment présente une sensibilité maximale.

Selon une seconde caractéristique de l'invention, le réseau est constitué par des répétitions d'un motif de base avec des décalages selon plusieurs directions de répétition qui sont distinctes dans la surface du support, de façon à former un réseau bidimensionnel de motifs identiques. Ainsi, lorsque les motifs comprennent individuellement plusieurs segments, chaque motif constitue un détecteur local qui est séparé des autres motifs, dans ou sur la surface du support, et qui est sensible à la direction de polarisation du rayonnement électromagnétique telle qu'elle existe à l'endroit de ce motif. Alors, des variations d'échauffement qui apparaissent entre des motifs distincts révèlent des variations spatiales de la polarisation du rayonnement électromagnétique, telles que ces variations spatiales de polarisation existent à un instant donné au niveau de la surface du support. Sinon, lorsque chaque motif ne comporte qu'un seul segment, au moins deux motifs voisins doivent être associés pour constituer un détecteur local de direction de polarisation.

Selon une troisième caractéristique de l'invention, le matériau sensible est un matériau conducteur électrique, avec une valeur de conductivité électrique de ce matériau sensible qui est comprise entre 10 S/m (siemens par mètre) et 500 S/m.

De façon générale, le réseau des motifs dans ou sur la surface du support peut être régulier ou aléatoire.

Un dispositif selon l'invention présente les avantages suivants :
- il permet d'identifier la direction de polarisation du rayonnement électromagnétique qui est effective localement, lorsque cette polarisation est rectiligne. Pour une polarisation elliptique, il permet d'évaluer le taux d'ellipticité qui est effectif localement ;
- il peut fournir une cartographie bidimensionnelle de la polarisation du rayonnement électromagnétique ;
- le support pourvu des motifs peut être de grandes dimensions, possiblement jusqu'à plusieurs mètres-carrés, donnant accès à des cartographies de polarisation dans des surfaces importantes ;
- le dispositif est efficace pour des fréquences du rayonnement électromagnétique qui peuvent varier dans une gamme très large : de quelques dizaines de hertz jusqu'à 1 THz (térahertz) environ pour un matériau des motifs qui est sensible au champ électrique, et jusqu'à 1 GHz (gigahertz) environ pour un matériau des motifs qui est sensible au champ magnétique ;
- le rayonnement électromagnétique peut être peu altéré par le dispositif, notamment lorsque les motifs recouvrent une faible fraction de la surface du support. En particulier, le dispositif peut ne générer presqu'aucun rayonnement réfléchi, si bien que les mesures peuvent être discrètes et non-perturbantes pour la source du rayonnement qui est caractérisé en utilisant le dispositif de l'invention ; et
- le dispositif peut permettre de caractériser des détails de la structure du rayonnement électromagnétique, qui ont des dimensions inférieures à la longueur d'onde de ce rayonnement.

Dans des modes particuliers de réalisation de l'invention, l'une au moins des caractéristiques additionnelles suivantes peut être reproduite optionnellement et préférentiellement, seule ou en combinaison de plusieurs d'entre elles :
- lorsque chaque motif comporte plusieurs segments rectilignes de matériau sensible, ces segments de chaque motif peuvent avoir de préférence au moins trois orientations différentes dans la surface du support, à l'intérieur du motif. Ainsi, la direction de polarisation rectiligne peut être déterminée de façon univoque à partir de chaque motif ;
- les décalages des répétitions du motif de base peuvent être combinés selon deux directions distinctes de répétition dans la surface du support, et peuvent être réguliers, de façon à ce que le réseau bidimensionnel de motifs identiques soit périodique selon chacune des deux directions de répétition, avec une période spatiale selon chacune de ces directions de répétition qui peut être comprise entre 100 µm (micromètre) et 50 mm (millimètre), de préférence comprise entre 1 mm et 30 mm. Cette période spatiale correspond à la résolution du dispositif selon la direction de répétition correspondante, pour déterminer des variations spatiales de la polarisation du rayonnement électromagnétique. En outre, les deux directions de répétition des motifs ne sont pas nécessairement perpendiculaires. Par exemple, elles peuvent former entre elles un angle de 60° (degré). De cette façon, les motifs peuvent être répartis dans la surface du support selon un réseau triangulaire équilatéral ;
- deux quelconques des motifs qui sont voisins dans la surface du support peuvent être intriqués l'un dans l'autre. Il est ainsi possible d'obtenir des résolutions qui sont plus fines, pour déterminer les variations spatiales de la polarisation du rayonnement électromagnétique ;
- les segments d'une paire quelconque de motifs qui sont voisins dans la surface du support peuvent être séparés par un intervalle inter-motif qui est dépourvu de matériau sensible, entre l'un quelconque des segments d'un premier motif de la paire et l'un quelconque des segments de l'autre motif de la paire. Ainsi, une perturbation du fonctionnement de détection d'un motif par un motif voisin est réduite ;
- deux quelconques des segments d'un même des motifs peuvent être isolés l'un de l'autre par un intervalle intra-motif qui est dépourvu de matériau sensible. Ainsi, un mélange parasite des fonctionnements de détection d'un motif entre des directions de polarisation rectiligne qui sont perpendiculaires, peut être réduit ;
- chaque motif peut être constitué par N segments qui sont disposés dans la surface du support, N étant un nombre entier qui peut être préférentiellement compris entre 3 et 16, les valeurs 3 et 16 étant incluses, et les orientations respectives des N segments de l'un quelconque des motifs peuvent être équi-réparties angulairement. En particulier, les segments de chacun des motifs peuvent être disposés radialement autour d'un centre du motif, de façon à former une étoile régulière à N branches dans la surface du support ; et
- chaque segment peut posséder une longueur qui est comprise entre 50 µm et 40 mm, de préférence comprise entre 1 mm et 30 mm, et une largeur qui est comprise entre 10 µm et 500 µm, de préférence comprise entre 100 µm et 300 µm, ces longueur et largeur étant mesurées parallèlement à la surface du support. Les valeurs de facteur de forme qui sont obtenues ainsi pour chaque segment procurent une bonne sélectivité du fonctionnement de détection de ce segment entre des composantes de polarisation rectiligne du rayonnement électromagnétique qui sont respectivement parallèle et perpendiculaire au segment.

Dans des modes préférés de réalisation de l'invention, la surface du support peut être constituée d'un matériau organique qui est isolant thermiquement et électriquement, par exemple à base de polyimide. Alors, le matériau sensible peut comprendre au moins un composé qui résulte d'une altération du matériau organique, notamment un composé de dégradation thermique du matériau organique. Le dispositif de l'invention peut ainsi présenter une sensibilité qui est particulièrement élevée, pour détecter des composantes de polarisation rectiligne du rayonnement électromagnétique. Il peut aussi être fabriqué de façon simple et économique.

De façon générale, le dispositif peut comprendre en outre une caméra thermique, qui est agencée pour saisir des images infrarouges de la surface du support pendant que cette surface du support est exposée au rayonnement électromagnétique. Ainsi, il est possible de faire apparaître dans les images saisies, des parties de certains au moins des segments du matériau sensible avec des intensités qui dépendent de valeurs de température respectives de ces parties de segments. Toutefois, d'autres systèmes de thermographie infrarouge peuvent être utilisés alternativement.

Selon un perfectionnement de l'invention, qui est destiné à augmenter encore la sensibilité de détection des composantes de polarisation du rayonnement électromagnétique, notamment pour détecter des composantes de polarisation rectiligne, le dispositif peut comprendre en outre :
- un système de modulation, qui est agencé pour appliquer une séquence temporelle de modulation au rayonnement électromagnétique auquel la surface du support est exposée ;
- un système de détection synchrone, qui est agencé pour filtrer les intensités saisies dans des images successives de la surface du support, conformément à la séquence temporelle de modulation ; et
- un système de traitement d'image, conçu pour déterminer automatiquement les caractéristiques de polarisation du rayonnement électromagnétique en certains points d'une image qui a été saisie, et éventuellement déterminer aussi des valeurs d'intensité du rayonnement électromagnétique relatives à ces points.

Un second aspect de l'invention propose un procédé de fabrication d'un dispositif qui est adapté pour révéler des variations spatiales de polarisation d'un rayonnement électromagnétique, ce procédé comprenant les étapes suivantes :
- fournir un support dont une surface est constituée d'un matériau organique isolant thermiquement et électriquement, par exemple d'un matériau à base de polyimide ; et
- chauffer le matériau organique sélectivement dans des zones déterminées de la surface du support, par exemple au moyen d'un faisceau laser qui est dirigé dans ces zones, de façon à altérer localement le matériau organique pour former le matériau sensible, notamment par dégradation thermique du matériau organique, afin de constituer les segments de matériau sensible.

Un tel procédé de fabrication est adapté pour fournir un dispositif qui est conforme au premier aspect de l'invention. Toutefois, d'autres procédés de fabrication sont aussi possibles, par exemple des procédés qui comprennent de déposer des portions du matériau sensible sélectivement aux endroits des motifs, et conformément à la forme des motifs.

### Brève description des figures

Les caractéristiques et avantages de la présente invention apparaîtront plus clairement dans la description détaillée ci-après d'exemples de réalisation non-limitatifs, en référence aux figures annexées parmi lesquelles :
[Fig. 1] est une vue en perspective d'un dispositif conforme à l'invention ;
[Fig. 2a] à [Fig. 2c] montrent différents motifs qui peuvent être utilisés alternativement pour le dispositif de [Fig. 1] ;
[Fig. 3a] à [Fig. 3e] montrent différentes répartitions de motifs qui peuvent être utilisées alternativement pour le dispositif de [Fig. 1] ;
[Fig. 4] illustre une mise en oeuvre d'un dispositif conforme à l'invention, pour révéler des variations spatiales de polarisation d'un rayonnement électromagnétique ;
[Fig. 5a] et [Fig. 5b] sont deux diagrammes qui montrent des amplitudes de densités de courant induites dans le dispositif de [Fig. 1], lorsque ce dispositif est mis en oeuvre avec le motif de [Fig. 2a] ; et
[Fig.6] illustre une façon de déterminer une direction locale de polarisation rectiligne d'un rayonnement électromagnétique, en utilisant le dispositif de [Fig. 1] mis en oeuvre avec le motif de [Fig. 2b].

### Description détaillée de l'invention

Pour raison de clarté, les dimensions des éléments qui sont représentés dans ces figures ne correspondent ni à des dimensions réelles, ni à des rapports de dimensions réels. En outre, des références identiques qui sont indiquées dans des figures différentes désignent des éléments identiques ou qui ont des fonctions identiques.

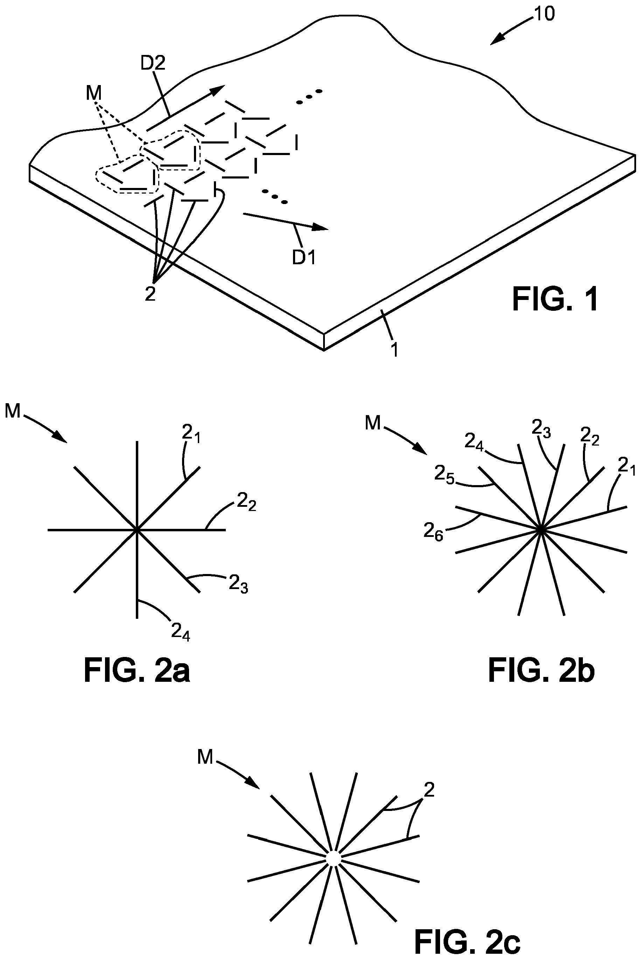

Conformément à [Fig. 1], un dispositif 10 selon l'invention comprend un support surfacique 1 qui est isolant électriquement, par exemple un film à base de polyimide tel que connu sous l'appellation film de Kapton^{®}. Le support 1 peut posséder une épaisseur qui est égale à environ 100 µm (micromètre), par exemple. De préférence, le matériau du support 1 possède une conductivité thermique qui est faible ou très faible, de sorte qu'il puisse être qualifié d'isolant thermique. Il est en outre de préférence transparent ou sensiblement transparent pour du rayonnement électromagnétique qui est destiné à être caractérisé en utilisant le dispositif 10.

Des motifs M d'un matériau qui est sensible au rayonnement électromagnétique sont répartis sur une surface du support 1. Ces motifs M sont identiques, de sorte qu'ils sont chacun une reproduction d'un motif de base et forment un réseau dans la surface du support 1. Ce réseau peut être périodique ou non. Lorsqu'il est périodique, les motifs M peuvent être décalés les uns par rapport aux autres selon des combinaisons quelconques de deux périodes spatiales parallèlement à une première direction de répétition notée D1 et à une seconde direction de répétition notée D2, respectivement. Par exemple, les deux périodes spatiales peuvent être égales à 24 mm, à titre d'exemple non-limitatif.

Chaque motif M est constitué par plusieurs segments rectilignes du matériau sensible au rayonnement électromagnétique, appelé matériau sensible, qui ont des orientations différentes dans la surface du support 1. De façon générale, chaque segment du matériau sensible peut avoir une longueur qui est comprise entre 50 µm et 40 mm, par exemple égale à 1 mm, et une largeur qui est comprise entre 10 µm et 500 µm, par exemple égale à 200 µm, ces longueur et largeur de segments étant mesurées parallèlement à la surface du support 1.

Par exemple, [Fig.1] montre des motifs M qui sont constitués chacun par quatre segments rectilignes 2, dont les orientations parallèlement à la surface du support 1 sont décalées de 45° (degré) entre deux segments quelconques d'un même motif M.

[Fig. 2a] montre un autre motif M qui peut être utilisé dans le dispositif de [Fig. 1] : les quatre segments rectilignes du matériau sensible du motif M sont disposés pour se couper en leurs milieux, de façon à constituer une étoile régulière à huit branches. Les quatre segments du matériau sensible qui constituent le motif M de [Fig. 2a] sont référencés 2₁, 2₂, 2₃ et 2₄, et peuvent avoir chacun une longueur égale à 20 mm.

[Fig. 2b] montre encore un autre motif M qui peut être utilisé dans le dispositif de [Fig. 1] : il est constitué par six segments rectilignes du matériau sensible qui sont disposés pour se couper en leurs milieux, de façon à constituer une étoile régulière à douze branches. Les six segments du matériau sensible qui constituent le motif M de [Fig. 2b] sont référencés 2₁ à 2₆. Ils peuvent encore avoir chacun une longueur égale à 20 mm.

[Fig. 2c] montre une variante du motif M de [Fig. 2b], dans laquelle chaque segment rectiligne du motif de [Fig. 2b] est interrompu autour de son milieu. Le motif M devient ainsi constitué par douze segments 2 qui sont disjoints les uns des autres au niveau du centre de l'étoile régulière à douze branches. Chacun des douze segments 2 peut alors avoir une longueur individuelle égale à 8 mm, encore à titre d'exemple. De tels motifs pour lesquels les points de croisement des segments sont dépourvus de matériau sensible permettent de réduire la valeur maximale de la température qui est mesurée pour chaque motif. Il est ainsi possible d'augmenter la dynamique de mesure de température pour les segments qui sont ainsi séparés.

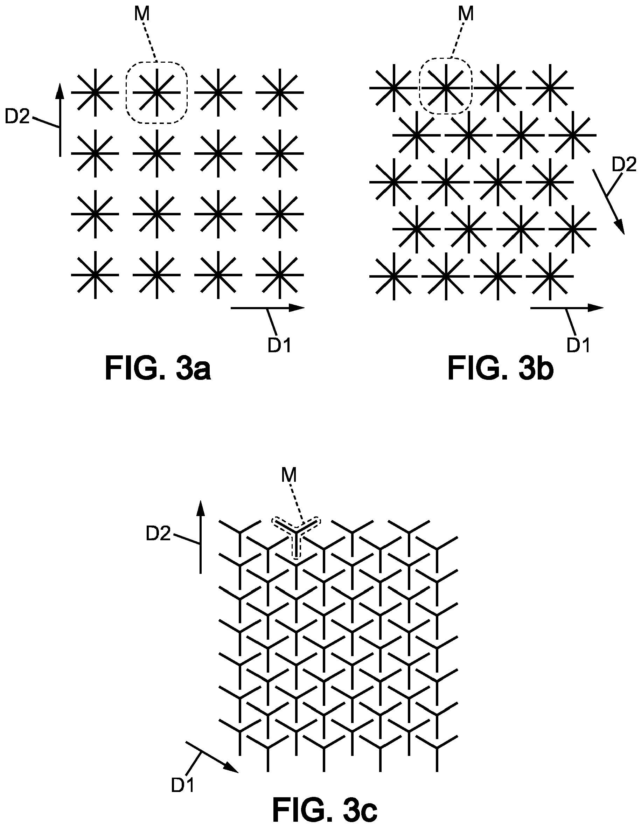

[Fig. 3a] montre un premier exemple possible de répartition des motifs M dans la surface du support 1, pour lequel les deux directions de répétition D1 et D2 sont perpendiculaires l'une à l'autre. Dans l'exemple représenté, les deux périodes spatiales selon les directions D1 et D2 sont égales, mais sans que ce soit indispensable. Ces périodes spatiales peuvent être comprises entre 100 µm et 50 mm, de préférence entre 1 mm et 30 mm, par exemple égale à 25 mm.

[Fig. 3b] correspond à [Fig. 3a], lorsque les deux directions D1 et D2 de répétition du motif M ne sont pas perpendiculaires l'une à l'autre, mais orientées par exemple à 60° environ l'une de l'autre.

De façon générale, la compacité du réseau des motifs M dans la surface du support 1 détermine une résolution spatiale de la caractérisation du rayonnement électromagnétique que procure le dispositif 10. En effet, chaque motif M est destiné à fournir séparément une caractérisation du rayonnement électromagnétique, concernant sa polarisation et possiblement aussi son intensité, tel que ce rayonnement existe à l'endroit du motif M. Pour un réseau périodique, cette résolution spatiale est déterminée par les périodes de répétition du motif M selon les directions D1 et D2.

Pour tous les modes de réalisation de l'invention dans lesquels chaque motif M comporte plusieurs segments rectilignes qui ont des orientations différentes à l'intérieur de chaque motif, chaque motif M est suffisant pour déterminer la polarisation du rayonnement électromagnétique à l'endroit de ce motif, hormis le sens de rotation de cette polarisation lorsqu'elle est circulaire ou elliptique. La résolution spatiale du dispositif 10 est alors sensiblement égale à la distance de séparation entre des centres respectifs de motifs qui sont voisins dans la surface du support 1.

[Fig. 3c] montre encore un autre exemple de motif M, qui est constitué d'une étoile régulière à trois branches. Un avantage de ce motif particulier est de permettre à des motifs M qui sont voisins d'être intriqués entre eux, de sorte que le réseau des motifs soit particulièrement compact dans la surface du support 1, comme cela est visible dans [Fig. 3c]. La résolution spatiale de la caractérisation du rayonnement électromagnétique que procure le dispositif 10 peut ainsi être particulièrement fine.

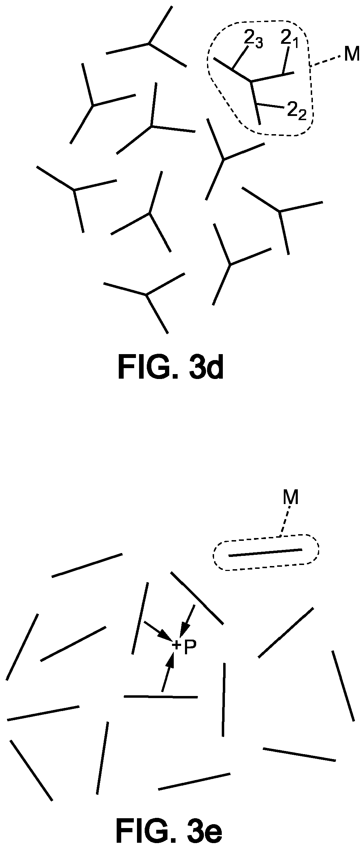

[Fig. 3d] montre encore un autre exemple de motif M, qui est constitué de trois branches disposées en « Y ». Les branches du motif M sont désignées par les références 2₁, 2₂ et 2₃. Les motifs M peuvent encore être imbriqués, mais sont répartis et orientés aléatoirement dans la surface du support 1.

[Fig. 3e] montre encore un autre exemple de dispositif 10 qui est conforme à l'invention, mais pour lequel chaque motif M n'est constitué que d'un seul segment rectiligne de matériau sensible. Les motifs M sont de nouveau répartis et orientés aléatoirement dans la surface du support 1. Pour un tel mode de réalisation de l'invention, deux ou trois motifs M qui sont voisins d'un point dans la surface du support 1, et dont les orientations sont différentes, sont nécessaires pour déterminer la polarisation du rayonnement électromagnétique qui est incident en ce point, en dehors du sens de rotation de cette polarisation lorsqu'elle est circulaire ou elliptique. Dans [Fig. 3e], les motifs M à utiliser pour déterminer la polarisation du rayonnement électromagnétique au point P sont reliés à ce point par des flèches.

Le matériau qui est sensible au rayonnement électromagnétique, et qui constitue les segments rectilignes de chaque motif M, peut être un matériau conducteur électrique, de type métallique, par exemple de l'argent ou du cuivre, ou faiblement conducteur électrique, tel qu'un matériau conducteur organique. On entend par matériau faiblement conducteur électrique un matériau dont la valeur de conductivité électrique est inférieure à 10⁴ S/m (siemens par mètre), par exemple typiquement de l'ordre de 10 S/m à 500 S/m. De façon connue, la puissance d'échauffement qui est provoquée par le rayonnement électromagnétique dans un matériau conducteur est proportionnelle au carré de l'amplitude de la composante du champ électrique qui est parallèle au segment rectiligne, et proportionnelle à la résistivité électrique du matériau conducteur.

Alternativement, le matériau qui est sensible au rayonnement électromagnétique, et qui constitue les segments rectilignes de chaque motif M, peut être un matériau diélectrique qui présente des pertes par polarisation diélectrique, tel que par exemple l'alumine (Al₂O₃), le nitrure d'aluminium (AIN), les oxydes de ruthénium (RuO₂) ou de nickel (NiO), le phosphate de fer (LiFePO₄), etc. Dans ce cas, et encore de façon connue, la puissance d'échauffement qui est provoquée par le rayonnement électromagnétique est proportionnelle au carré de l'amplitude de la composante du champ électrique qui est parallèle au segment rectiligne, et proportionnelle à la partie imaginaire du coefficient de susceptibilité diélectrique du matériau sensible.

Encore alternativement, le matériau qui est sensible au rayonnement électromagnétique, et qui constitue les segments rectilignes de chaque motif M, peut être un matériau magnétique qui présente des pertes par polarisation magnétique. Un tel matériau peut être notamment du type ferromagnétique, tel que par exemple de l'oxyde ferrique (Fe₂O₃). Dans cet autre cas, et encore de façon connue, la puissance d'échauffement qui est provoquée par le rayonnement électromagnétique est proportionnelle au carré de l'amplitude de la composante du champ magnétique qui est parallèle au segment rectiligne, et proportionnelle à la partie imaginaire du coefficient de susceptibilité magnétique du matériau sensible.

Or la puissance du rayonnement électromagnétique est proportionnelle au carré de l'amplitude du champ électrique, ou du champ magnétique de façon équivalente. Alors, lorsque le rayonnement électromagnétique est polarisé rectilignement, la puissance d'échauffement d'un segment rectiligne du matériau sensible est environ proportionnelle dans tous les cas à la puissance du rayonnement électromagnétique multipliée par le carré du cosinus de l'angle entre la direction longitudinale du segment rectiligne et la direction du champ électrique ou magnétique, selon celui des champs électrique ou magnétique auquel est sensible le matériau du segment. Autrement dit, l'échauffement d'un segment rectiligne du matériau sensible est environ proportionnel au carré du produit scalaire entre le vecteur unitaire du segment rectiligne et le champ électrique ou magnétique, selon celui de ces champs auquel est sensible le matériau du segment.

Les motifs M du matériau sensible peuvent être formés sur la surface du support 1 en utilisant un procédé de dépôt sélectif tel que connu de l'Homme du métier. Par exemple, un tel procédé connu peut mettre en oeuvre un masque, dont les ouvertures déterminent les dimensions et la position de chaque segment rectiligne d'un des motifs M sur le support 1. Le dépôt du matériau sensible est alors effectué à travers les ouvertures du masque. Alternativement, les dimensions et la position de chaque segment rectiligne de motif M peuvent être déterminées par un procédé d'accrochage sélectif du matériau sensible, appliqué à des endroits qui sont répartis dans la surface du support 1. Un tel procédé d'accrochage sélectif peut comprendre d'activer localement le matériau du support 1, afin de produire une adhésion du matériau sensible sur le support 1, ou de déposer sélectivement une couche d'accrochage qui est adaptée pour être adhérente d'une part au support 1, et d'autre part aussi adhérente au matériau sensible. Alternativement encore, une couche continue du matériau sensible peut être d'abord formée sur la surface du support 1, puis gravée sélectivement à l'aide d'un laser ou par un procédé chimique à travers un masque.

Lorsque le support 1 est à base d'un matériau organique, tel que le Kapton^{®}, des composés de dégradation thermique de ce matériau organique peuvent constituer le matériau sensible. En particulier, ces composés de dégradation thermique peuvent comprendre des particules de carbone graphite. Le matériau sensible qui est ainsi obtenu est du type conducteur électrique à faible valeur de conductivité. Dans ce cas, les motifs M de matériau sensible peuvent être simplement obtenus en chauffant localement et sélectivement le support 1 aux endroits voulus pour les motifs M. Un tel chauffage local et sélectif peut être réalisé au moyen d'un faisceau laser, en déplaçant ce faisceau laser aux endroits voulus pour les motifs M, selon une vitesse de déplacement qui est appropriée pour délivrer localement la puissance thermique qui est nécessaire pour convertir le matériau organique en matériau sensible. En fonction du matériau organique qui est sélectionné pour constituer le support 1, l'Homme du métier sait choisir la longueur d'onde du laser, sa puissance ainsi que la vitesse de déplacement du laser sur la surface du support 1 pour obtenir le matériau sensible voulu. Le matériau sensible ainsi obtenu peut être caractérisé en mettant en oeuvre un des procédés connus d'analyse locale de matériau, et un des procédés connus de mesure locale de conductivité électrique.

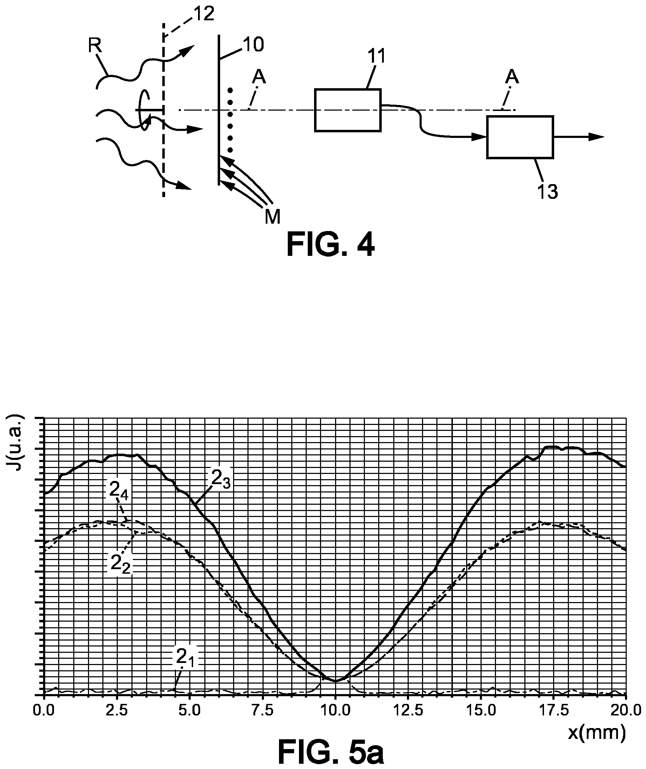

[Fig. 4] illustre une mise en oeuvre possible du dispositif 10. Le dispositif 10, par exemple en forme de film qui porte les motifs M de matériau sensible, est disposé dans le rayonnement électromagnétique R à caractériser, et une caméra thermique 11 est disposée pour saisir des images infrarouges de la surface du support du dispositif 10 qui porte les motifs M. De préférence, cette surface qui porte les motifs M en matériau sensible peut être tournée vers la caméra thermique 11. La caméra thermique 11 peut être de l'un des modèles disponibles commercialement, à capteur d'image matriciel sensible aux longueurs d'onde qui sont comprises entre 3 µm et 5 µm, par exemple un capteur matriciel de type InSb refroidi. Préférablement, un axe optique A-A de la caméra 11 peut être perpendiculaire à la surface du support du dispositif 10 qui porte les motifs M. De cette façon, l'ensemble des motifs M du dispositif 10 peut apparaître de façon nette dans les images infrarouges qui sont saisies par la caméra 11.

Lorsque le rayonnement électromagnétique R est incident continuellement sur le dispositif 10, il provoque un échauffement de certains des segments rectilignes des motifs M, en fonction de la polarisation du rayonnement R et en fonction de l'orientation de cette polarisation par rapport à chaque segment rectiligne. Les segments rectilignes dont la température croît ainsi sous l'effet du rayonnement R apparaissent alors avec des intensités supérieures dans les images infrarouges qui sont saisies par la caméra thermique 11. Toutefois, des phénomènes thermiques parasites tels que la diffusion thermique dans le support 1, la diffusion thermique dans l'air qui est au contact avec la surface du support 1 qui porte les motifs M, et la convection thermique qui peut apparaître dans l'air à proximité du support 1, tendent à réduire les écarts de température qui sont générés par le rayonnement R entre des segments rectilignes différents du matériau sensible, que ces segments appartiennent à un même motif M ou à des motifs M différents, et entre chaque segment rectiligne du matériau sensible et le support 1 en dehors des motifs M. Le contraste des images infrarouges qui sont saisies par la caméra thermique 11 est alors diminué. Selon un perfectionnement de l'invention qui pallie une telle réduction du contraste des images saisies, le rayonnement électromagnétique R qui est incident sur le dispositif 10 peut être modulé en intensité. Une telle modulation peut être appliquée par la source du rayonnement R lorsque cela est possible, ou par un système de modulation 12 qui est disposé sur le trajet du rayonnement R avant que ce rayonnement parvienne au dispositif 10. Par exemple, le système de modulation 12 peut être un écran mobile qui présente au moins une ouverture, tel qu'une roue dont des secteurs angulaires sont sélectivement constitués de matériau opaque ou transparent au rayonnement R, et qui est entraînée en rotation par un moteur à vitesse contrôlée. Le système 12 applique ainsi une modulation d'intensité au rayonnement R qui est incident sur le dispositif 10, à une fréquence qui peut être comprise entre 1 Hz (hertz) et 100 Hz, par exemple. Les intensités de points d'image qui sont mesurées par la caméra thermique 11 sont alors filtrées par un système de détection synchrone 13, conformément à la modulation qui est appliquée à la source du rayonnement R ou par le système 12. Un tel mode de saisie d'image avec détection synchrone permet de supprimer des contributions thermiques continues qui sont produites par l'un au moins des phénomènes thermiques parasites mentionnés plus haut. Typiquement, le rayonnement R modulé provoque une série d'impulsions successives d'augmentation de température dans certains des segments rectilignes des motifs M du dispositif 10, et ces impulsions sont sélectivement détectées dans les images infrarouges après filtrage par le système de démodulation 13.

Le diagramme de [Fig. 5a] montre la répartition de la densité de courant électrique qui est induite dans un motif M du dispositif 10, pour un motif tel que représenté dans [Fig. 2a], lorsque le rayonnement électromagnétique R qui est incident sur ce motif possède une polarisation rectiligne du champ électrique, parallèle au segment rectiligne 2s. Dans le cas de [Fig. 5a], le matériau sensible est un oxyde métallique dont la conductivité électrique est de l'ordre de 1000 S/m, et la largeur de chacun des segments 2₁-2₄ est égale à 200 µm. L'axe horizontal repère la position le long de chacun des segments 2₁-2₄, d'une extrémité de chaque segment à l'autre pour une longueur de segment égale à 20 mm. Cette position est notée x. L'axe vertical repère l'amplitude de la densité de courant, notée J et exprimée en unité arbitraire (u.a.). La courbe relative à chaque segment du motif M de [Fig. 2a] est désignée par la référence de ce segment. Comme le montrent les courbes du diagramme de [Fig 5a], la densité de courant qui est induite dans le segment 2₃ est la plus grande, puisque ce segment 2₃ est parallèle au champ électrique du rayonnement R, la densité de courant qui est induite dans le segment 2₁ est sensiblement nulle, car ce segment 2₁ est perpendiculaire au champ électrique du rayonnement R, et les densités de courant qui sont induites dans les segments 2₂ et 2₄ sont intermédiaires et sensiblement égales, car les deux segments 2₂ et 2₄ sont chacun à 45° du champ électrique. Toutefois, à cause du caractère très conducteur du matériau sensible, avec une valeur de conduction électrique qui est élevée, une résonance apparaît au sein de chacun des segments 2₂-2₄, du type effet d'antenne en mode de réception. Du fait de ce comportement de résonance, les courbes relatives aux segments 2₂-2₄ présentent chacune un maximum de l'amplitude de la densité de courant induite. L'échauffement local qui est provoqué par le rayonnement R en chaque point d'un des segments 2₁-2₄ est proportionnel au carré de l'amplitude de la densité de courant qui est induite en ce point. Ainsi, dans les images infrarouges qui sont saisies par la caméra thermique 11, les extrémités du segment 2₃ apparaissent les plus brillantes, plus précisément les parties de ce segment qui sont situées à 2,5 mm environ de chacune de ses deux extrémités apparaissent plus brillantes. Les segments 2₂ et 2₄ apparaissent chacun dans les images saisies de façon similaire au segment 2s, mais en étant moins brillants, et le segment 2₁ apparaît sombre selon la température du support 1, sauf en son centre où sa température est augmentée du fait de la conduction thermique à partir des parties proches des autres segments 2₂-2₄.

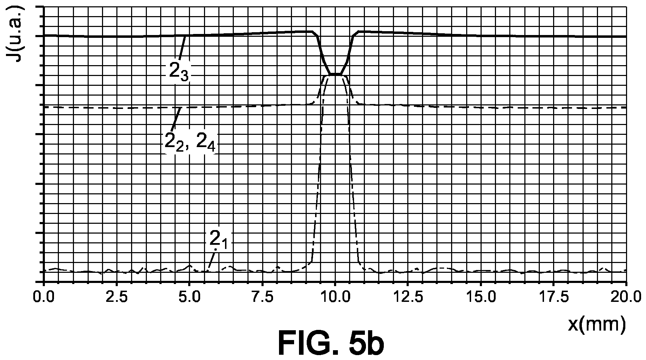

[Fig. 5b] correspond à [Fig. 5a] lorsque le matériau sensible est encore de type conducteur électrique, mais avec une valeur de conductivité électrique beaucoup plus faible, de l'ordre de 20 S/m. Cette valeur correspond à un support 1 en Kapton^{®} qui a été chauffé localement par laser pour former le matériau sensible. Le comportement de résonance n'existe plus, de sorte que l'amplitude de la densité du courant électrique qui est induite dans chaque segment est sensiblement constante en dehors d'une zone restreinte autour du milieu de ce segment. Comme précédemment, cette amplitude de densité de courant induite dépend de l'orientation du segment par rapport à la direction de polarisation rectiligne du champ électrique du rayonnement R. La suppression d'une intersection entre les segments d'un même motif en étoile, comme introduite entre [Fig. 2b] et [Fig. 2c] évite que le centre de l'étoile apparaisse en surbrillance dans les images infrarouges saisies.

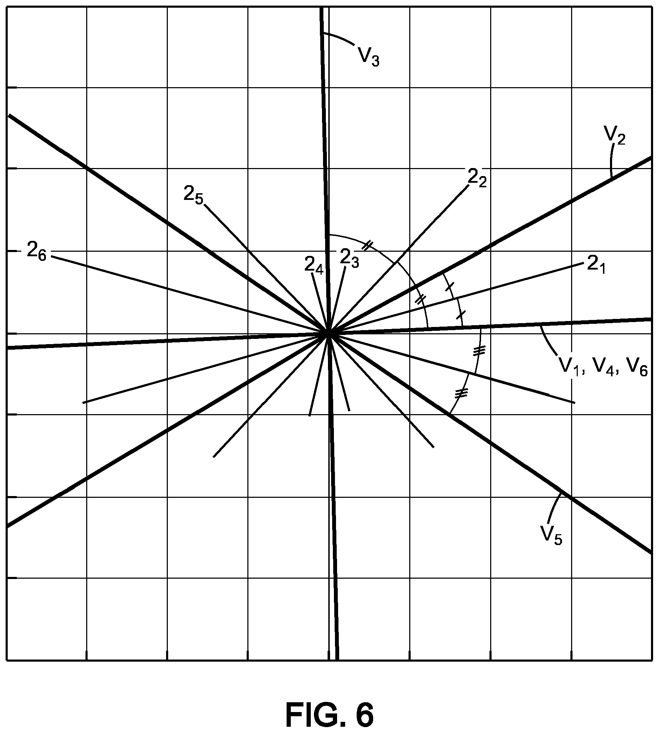

Le diagramme de [Fig. 6] repère, dans un plan qui est parallèle à la surface d'un support 1 qui porte le motif M de [Fig. 2b], les directions des segments 2₁-2₆ du motif. Ces directions apparaissent dans le diagramme conformément à leurs orientations respectives réelles, et sont désignées par les références des segments rectilignes correspondants. En outre, chaque direction de segment dans le diagramme de [Fig. 6] est associée à une longueur de représentation qui est proportionnelle à l'échauffement du segment, tel que lu dans les images infrarouges saisies par la caméra thermique 11. Les segments 2₁ et 2₄, qui sont perpendiculaires entre eux dans l'exemple considéré mais sans que ce soit indispensable, forment une première base de polarisation rectiligne. De même, les segments 2₂ et 2₅ forment une deuxième base de polarisation rectiligne, et les segments 2₃ et 2₆ forment une troisième base de polarisation rectiligne. Pour chacune de ces bases séparément, le rapport des longueurs de représentation des deux directions de segments de cette base indique deux directions distinctes qui sont possibles pour la polarisation rectiligne du rayonnement R. Ces deux directions possibles de polarisation sont symétriques par rapport aux directions de segments de la base. Ainsi, d'après la première base (segments 2₁ et 2₄), les directions possibles pour la polarisation rectiligne du rayonnement R sont V₁ et V₂, telles qu'indiquées dans le diagramme. Ces deux directions possibles de polarisation rectiligne sont plus proches angulairement de celle des directions de segments de la base qui correspond à une élévation de température supérieure (direction du segment 2₁ dans l'exemple considéré). De même, les directions qui sont possibles pour la polarisation rectiligne du rayonnement R sont V₃ et V₄ d'après la deuxième base (segments 2₃ et 2₅), et sont V₅ et V₆ d'après la troisième base (segments 2₃ et 2₆). La concordance entre ces possibilités qui résultent séparément des trois bases de polarisation rectiligne du motif M est la coïncidence entre les directions V₁, V₄ et V₆. Cette direction de coïncidence, V₁=V₄=V₆, est donc la direction de la polarisation rectiligne du rayonnement électromagnétique R à l'endroit du motif M considéré. Cet exemple correspond à l'étoile à douze branches de [Fig. 6], créant trois bases orthonormées dans le plan du motif M. Le même raisonnement s'applique à l'étoile à huit branches de [Fig. 2a], créant deux bases orthonormées qui donneront donc quatre directions potentielles de polarisation rectiligne, dont deux seulement coïncideront l'une avec l'autre pour indiquer la direction réelle de la polarisation rectiligne. Un motif M en étoile à trois branches non-orthogonales deux-à-deux, tel que représenté dans [Fig. 3d], crée deux bases non-orthonormées qui donneront également quatre directions potentielles, dont deux coïncideront l'une avec l'autre pour indiquer la direction réelle de polarisation rectiligne. Le raisonnement s'applique de façon générale à tout motif en étoile à N branches qui définit au moins trois directions.

Le procédé de détermination de la direction de polarisation rectiligne qui vient d'être décrit en référence à [Fig. 6] peut être répété indépendamment pour plusieurs des motifs M du dispositif 10. La direction de la polarisation rectiligne du rayonnement électromagnétique R est ainsi déterminée aux endroits de ces motifs M, de sorte que des variations spatiales de cette polarisation peuvent être mises en évidence.

Ce procédé de détermination de la polarisation peut aussi être appliqué dans un cas où la polarisation du rayonnement électromagnétique est elliptique à l'endroit du motif M qui est utilisé. L'orientation des axes de l'ellipse de polarisation est alors obtenue, ainsi qu'éventuellement une valeur du quotient entre les longueurs respectives du grand axe et du petit axe de l'ellipse de polarisation.

Il est entendu que l'invention peut être reproduite en modifiant des aspects secondaires des modes de réalisation qui ont été décrits en détail ci-dessus, tout en conservant certains au moins des avantages cités. Notamment, des motifs M qui présentent des agencements de segments rectilignes de matériau sensible qui sont différents de ceux présentés, peuvent être utilisés alternativement.

II est aussi rappelé que des segments rectilignes de matériau sensible qui sont séparés peuvent être utilisés pour constituer chacun un motif distinct, et que de tels motifs à un seul segment par motif peuvent être répartis selon un réseau aléatoire et orientés chacun aléatoirement dans ou sur la surface du support.

De façon générale, les motifs peuvent posséder des orientations aléatoires dans un même dispositif qui est conforme à l'invention. En outre, ils peuvent être distribués régulièrement ou aléatoirement dans ou sur la surface du support, y compris aléatoirement sur une grille régulière.

Par ailleurs, les raisonnements qui ont été présentés plus particulièrement pour un matériau sensible du type conducteur électrique, peuvent être transposés sans difficulté à des matériaux sensibles diélectriques ou magnétiques.

Enfin, toutes les valeurs numériques qui ont été citées ne l'ont été qu'à titre d'illustration, et peuvent être changées en fonction de l'application considérée.

## Revendications

1. Dispositif (10) adapté pour révéler des variations spatiales de polarisation d'un rayonnement électromagnétique (R), sous forme de variations de température localisées,
le dispositif (10) comprenant une surface d'un support (1) qui est isolante thermiquement et électriquement, et comportant dans ou sur la surface du support, un réseau de motifs (M) qui sont constitués chacun d'au moins un segment rectiligne (2) d'un matériau, appelé matériau sensible,
le matériau sensible étant adapté pour produire un échauffement lorsque ledit matériau sensible est exposé à un champ électrique ou à un champ magnétique du rayonnement (R), avec une valeur d'un taux de puissance d'échauffement par rapport à une puissance du rayonnement électromagnétique qui varie en fonction d'une polarisation dudit rayonnement électromagnétique par rapport à une orientation de chaque segment (2) dans la surface du support (1),
ledit taux de puissance d'échauffement par rapport à la puissance du rayonnement électromagnétique étant sensiblement nul dans le support en dehors des segments (2) du matériau sensible, quelle que soit la polarisation du rayonnement (R),
dispositif (10) dans lequel, si chaque motif (M) comporte plusieurs segments, ces segments (2) à l'intérieur de chaque motif ont au moins deux orientations différentes, ou dans lequel, si chaque motif ne comporte qu'un seul segment, les segments de deux motifs qui sont voisins ont des orientations différentes,
le réseau étant constitué par des répétitions d'un motif de base avec des décalages selon plusieurs directions de répétition (D1, D2) qui sont distinctes dans la surface du support (1), de façon à former un réseau bidimensionnel de motifs (M) identiques,
le dispositif (10) étant **caractérisé en ce que** le matériau sensible est un matériau conducteur électrique, avec une valeur de conductivité électrique dudit matériau sensible qui est comprise entre 10 S/m et 500 S/m.

2. Dispositif (10) selon la revendication 1, dans lequel chaque motif (M) comporte plusieurs segments (2) rectilignes de matériau sensible, et les segments de chaque motif ont au moins trois orientations différentes dans la surface du support (1), à l'intérieur dudit motif.

3. Dispositif (10) selon la revendication 1 ou 2, dans lequel les décalages des répétitions du motif de base sont combinés selon deux directions distinctes de répétition (D1, D2) dans la surface du support (1), et sont réguliers, de façon à ce que le réseau bidimensionnel de motifs (M) identiques soit périodique selon chacune des deux directions de répétition, avec une période spatiale selon chacune desdites directions de répétition qui est comprise entre 100 µm et 50 mm, de préférence comprise entre 1 mm et 30 mm.

4. Dispositif (10) selon l'une quelconque des revendications précédentes, dans lequel deux quelconques des motifs (M) qui sont voisins dans la surface du support (1) sont intriqués l'un dans l'autre.

5. Dispositif (10) selon l'une quelconque des revendications précédentes, dans lequel les segments (2) d'une paire quelconque de motifs (M) qui sont voisins dans la surface du support (1) sont séparés par un intervalle inter-motif qui est dépourvu de matériau sensible, entre l'un quelconque des segments d'un premier motif de la paire et l'un quelconque des segments de l'autre motif de la paire.

6. Dispositif (10) selon l'une quelconque des revendications précédentes, dans lequel deux quelconques des segments (2) d'un même des motifs (M) sont isolés l'un de l'autre par un intervalle intra-motif qui est dépourvu de matériau sensible.

7. Dispositif (10) selon l'une quelconque des revendications précédentes, dans lequel chaque motif (M) est constitué par N segments (2) qui sont disposés dans la surface du support (1), N étant un nombre entier compris entre 3 et 16, les valeurs 3 et 16 étant incluses, et dans lequel les orientations respectives des N segments de l'un quelconque des motifs sont équi-réparties angulairement.

8. Dispositif (10) selon la revendication 7, dans lequel les segments (2) de chacun des motifs (M) sont disposés radialement autour d'un centre du motif, de façon à former une étoile régulière à N branches dans la surface du support (1).

9. Dispositif (10) selon l'une quelconque des revendications précédentes, dans lequel chaque segment (2) possède une longueur qui est comprise entre 50 µm et 40 mm, de préférence comprise entre 1 mm et 30 mm, et une largeur qui est comprise entre 10 µm et 500 µm, de préférence comprise entre 100 µm et 300 µm, lesdites longueur et largeur étant mesurées parallèlement à la surface du support (1).

10. Dispositif (10) selon l'une quelconque des revendications précédentes, dans lequel la surface du support (1) est constituée d'un matériau organique qui est isolant thermiquement et électriquement, par exemple à base de polyimide, et dans lequel le matériau sensible comprend au moins un composé qui résulte d'une altération du matériau organique, notamment un composé de dégradation thermique du matériau organique.

11. Dispositif (10) selon l'une quelconque des revendications précédentes, comprenant en outre une caméra thermique (11), agencée pour saisir des images infrarouges de la surface du support (1) pendant que ladite surface du support est exposée au rayonnement électromagnétique (R), de façon à faire apparaître dans les images saisies, des parties de certains au moins des segments (2) du matériau sensible avec des intensités qui dépendent de valeurs de température respectives desdites parties de segments.

12. Dispositif (10) selon la revendication 11, comprenant en outre :
- un système de modulation (12), qui est agencé pour appliquer une séquence temporelle de modulation au rayonnement électromagnétique (R) auquel la surface du support (1) est exposée ; et
- un système de détection synchrone (13), qui est agencé pour filtrer les intensités saisies dans des images successives de la surface du support, conformément à la séquence temporelle de modulation.

13. Procédé de fabrication d'un dispositif (10) adapté pour révéler des variations spatiales de polarisation d'un rayonnement électromagnétique (R), ledit dispositif étant conforme à l'une quelconque des revendications précédentes, le procédé de fabrication comprenant les étapes suivantes :
- fournir un support (1) dont une surface est constituée d'un matériau organique isolant thermiquement et électriquement, par exemple d'un matériau à base de polyimide ; et
- chauffer le matériau organique sélectivement dans des zones déterminées de la surface du support (1), par exemple au moyen d'un faisceau laser qui est dirigé dans lesdites zones, de façon à altérer localement ledit matériau organique pour former le matériau sensible, notamment par dégradation thermique du matériau organique, afin de constituer les segments (2) de matériau sensible.

## Patentansprüche

1. Vorrichtung (10) die angepasst ist, um räumliche Veränderungen einer Polarisation elektromagnetischer Strahlung (R) in Form von lokalisierten Temperaturveränderungen zu erkennen,
wobei die Vorrichtung (10) eine Oberfläche eines Trägers (1) umfasst, die thermisch und elektrisch isolierend ist, und in oder auf der Oberfläche des Trägers ein Netz aus Motiven (M) beinhaltet, die jeweils aus mindestens einem geradlinigen Segment (2) eines Werkstoffs, empfindlicher Werkstoff genannt, bestehen,
wobei der empfindliche Werkstoff angepasst ist, um eine Erwärmung zu erzeugen, wenn der empfindliche Werkstoff einem elektrischen Feld oder einem Magnetfeld der Strahlung (R) ausgesetzt ist, wobei sich ein Wert einer Erwärmungsleistungsrate in Bezug auf eine Leistung der elektromagnetischen Strahlung in Abhängigkeit von einer Polarisation der elektromagnetischen Strahlung in Bezug auf eine Ausrichtung eines jeden Segments (2) in der Oberfläche des Trägers (1) verändert,
wobei die Erwärmungsleistungsrate in Bezug auf eine Leistung der elektromagnetischen Strahlung im Träger außerhalb der Segmente (2) des empfindlichen Werkstoffs unabhängig von der Polarisation der Strahlung (R) im Wesentlichen null ist,
wobei in der Vorrichtung (10), wenn jedes Motiv (M) mehrere Segmente beinhaltet, diese Segmente (2) im Inneren eines jeden Motivs mindestens zwei unterschiedliche Ausrichtungen aufweisen, oder wobei, wenn jedes Motiv nur ein Segment beinhaltet, die Segmente zweier benachbarter Motive unterschiedliche Ausrichtungen aufweisen,
wobei das Netz aus Wiederholungen eines Grundmotivs mit Versätzen in mehreren Wiederholungsrichtungen (D1, D2) besteht, die sich in der Oberfläche des Trägers (1) unterscheiden, um ein zweidimensionales Netz aus identischen Motiven (M) zu bilden,
wobei die Vorrichtung (10) **dadurch gekennzeichnet ist, dass** der empfindliche Werkstoff ein elektrisch leitender Werkstoff ist, wobei ein elektrischen Leitfähigkeitswert des empfindlichen Werkstoffs zwischen 10 S/m und 500 S/m liegt.

2. Vorrichtung (10) nach Anspruch 1, wobei jedes Motiv (M) mehrere geradlinige Segmente (2) aus empfindlichem Werkstoff beinhaltet und die Segmente eines jeden Motivs mindestens drei verschiedene Ausrichtungen in der Oberfläche des Trägers (1) im Inneren des Motivs aufweisen.

3. Vorrichtung (10) nach Anspruch 1 oder 2, wobei die Versätze der Wiederholungen des Grundmotivs in zwei unterschiedlichen Wiederholungsrichtungen (D1, D2) in der Oberfläche des Trägers (1) kombiniert sind, und regelmäßig sind, sodass das zweidimensionale Netz aus identischen Motiven (M) in jeder der beiden Wiederholungsrichtungen periodisch ist, wobei eine räumliche Periode in jeder der Wiederholungsrichtungen zwischen 100 µm und 50 mm liegt, vorzugsweise zwischen 1 mm und 30 mm liegt.

4. Vorrichtung (10) nach einem der vorstehenden Ansprüche, wobei zwei beliebige der Motive (M), die in der Oberfläche des Trägers (1) benachbart sind, ineinander verschränkt sind.

5. Vorrichtung (10) nach einem der vorstehenden Ansprüche, wobei die Segmente (2) eines beliebigen Paares von Motiven (M) die in der Oberfläche des Trägers (1) benachbart sind, durch ein Zwischenmotivintervall, das mit keinem empfindlichen Werkstoff versehen ist, zwischen dem einen beliebigen der Segmente eines ersten Motivs des Paares und einem beliebigen der Segmente des anderen Motivs des Paares getrennt sind.

6. Vorrichtung (10) nach einem der vorstehenden Ansprüche, wobei zwei beliebige der Segmente (2) eines gleichen der Motive (M) voneinander durch ein Intervall innerhalb des Motivs isoliert sind, das mit keinem empfindlichen Werkstoff versehen ist.

7. Vorrichtung (10) nach einem der vorstehenden Ansprüche, wobei jedes Motiv (M) aus N Segmenten (2) besteht, die in der Oberfläche des Trägers (1) angeordnet sind, wobei N eine ganze Zahl ist, die zwischen 3 und 16 liegt, wobei die Werte 3 und 16 enthalten sind, und wobei die jeweiligen Ausrichtungen der N Segmente des einen beliebigen der Motive winkelig gleichverteilt sind.

8. Vorrichtung (10) nach Anspruch 7, wobei die Segmente (2) eines jeden der Motive (M) radial um eine Mitte des Motivs angeordnet sind, um einen regelmäßigen Stern mit N Ästen in der Oberfläche des Trägers (1) zu bilden.

9. Vorrichtung (10) nach einem der vorstehenden Ansprüche, wobei jedes Segment (2) eine Länge besitzt, die zwischen 50 µm und 40 mm, vorzugsweise zwischen 1 mm und 30 mm liegt, und eine Breite, die zwischen 10 µm und 500 µm, vorzugsweise zwischen 100 µm und 300 µm liegt, wobei die Länge und Breite parallel zur Oberfläche des Trägers (1) gemessen werden.

10. Vorrichtung (10) nach einem der vorstehenden Ansprüche, wobei die Oberfläche des Trägers (1) aus einem organischen Werkstoff besteht, der thermisch und elektrisch isolierend ist, beispielsweise auf Basis von Polyimid, und wobei der empfindliche Werkstoff mindestens eine Zusammensetzung umfasst, die sich aus einer Änderung des organischen Werkstoffs, insbesondere einer Zusammensetzung aus thermischem Abbau des organischen Werkstoffs ergibt.

11. Vorrichtung (10) nach einem der vorstehenden Ansprüche, die weiter eine Wärmekamera (11) umfasst, die angeordnet ist, um Infrarotbilder der Oberfläche des Trägers (1) aufzunehmen, während die Oberfläche des Trägers der elektromagnetischen Strahlung (R) ausgesetzt ist, um in den aufgenommenen Bildern Teile von mindestens bestimmten der Segmente (2) des empfindlichen Werkstoffs mit Intensitäten erscheinen zu lassen, die von jeweiligen Temperaturwerten der Teile von Segmenten abhängig sind.

12. Vorrichtung (10) nach Anspruch 11, weiter umfassend:
- ein Modulationssystem (12), das angeordnet ist, um eine zeitliche Modulationsfolge auf die elektromagnetische Strahlung (R) anzuwenden, welcher die Oberfläche des Trägers (1) ausgesetzt ist; und
- ein synchrones Erkennungssystem (13), das angeordnet ist, um die in den aufeinanderfolgenden Bildern der Oberfläche des Trägers erfassten Intensitäten entsprechend der zeitlichen Modulationsfolge zu filtern.

13. Verfahren zur Herstellung einer Vorrichtung (10), die angepasst ist, um räumliche Veränderungen einer Polarisation elektromagnetischer Strahlung (R) zu erkennen, wobei die Vorrichtung nach einem der vorstehenden Ansprüche ist, wobei das Verfahren zur Herstellung die folgenden Schritte umfasst:
- Bereitstellen eines Trägers (1), dessen eine Oberfläche aus einem thermisch und elektrisch isolierenden organischen Werkstoff, beispielsweise einem Werkstoff auf Basis von Polyimid besteht; und
- Erwärmen des organischen Werkstoffs selektiv in den bestimmten Bereichen der Oberfläche des Trägers (1), beispielsweise anhand eines Laserstrahls, der auf die Bereiche gerichtet ist, um den organischen Werkstoff lokal zu ändern, um den empfindlichen Werkstoff insbesondere durch thermischen Abbau des organischen Werkstoffs zu bilden, um die Segmente (2) aus empfindlichem Werkstoff zu erstellen.

## Claims

1. A device (10) suitable for revealing spatial variations in the polarisation of electromagnetic radiation (R), in the form of localised temperature variations, the device (10) comprising a surface of a carrier (1) that is thermally and electrically insulating, and including in or on the surface of the carrier, an array of patterns (M) that each consist of at least one rectilinear segment (2) of a material, called sensitive material,
the sensitive material being suitable for producing heating when said sensitive material is exposed to an electric field or a magnetic field of the radiation (R), with a value of a heating power rate relative to a power of the electromagnetic radiation which varies according to a polarisation of said electromagnetic radiation relative to an orientation of each segment (2) in the surface of the carrier (1),
said rate of heating power relative to the electromagnetic radiation power being substantially zero in the carrier outside the segments (2) of the sensitive material, regardless of the polarisation of the radiation (R),
device (10) wherein, if each pattern (M) includes several segments, these segments (2) within each pattern have at least two different orientations, or wherein, if each pattern includes only one segment, the segments of two patterns that are neighbours have different orientations,
the array being constituted by repetitions of a basic pattern with offsets in several repetition directions (D1, D2) which are distinct in the surface of the carrier (1), so as to form a two-dimensional array of identical patterns (M),
the device (10) being **characterised in that** the sensitive material is an electrically conductive material, with an electrical conductivity value of said sensitive material which is comprised between 10 S/m and 500 S/m.

2. The device (10) according to claim 1, wherein each pattern (M) includes several rectilinear segments (2) of sensitive material, and the segments of each pattern have at least three different orientations in the surface of the carrier (1), inside said pattern.

3. The device (10) according to claim 1 or 2, wherein the offsets of the repetitions of the basic pattern are combined in two distinct directions of repetition (D1, D2) in the surface of the carrier (1), and are regular, so that the two-dimensional array of identical patterns (M) is periodic in each of the two repetition directions, with a spatial period in each of said repetition directions which is comprised between 100 µm and 50 mm, preferably comprised between 1 mm and 30mm.

4. The device (10) according to any one of the preceding claims, wherein any two of the patterns (M) that are neighbours in the surface of the carrier (1) are entangled with one another.

5. The device (10) according to any one of the preceding claims, wherein the segments (2) of any pair of patterns (M) that are neighbours in the surface of the carrier (1) are separated by an inter-pattern interval which is devoid of sensitive material, between any of the segments of a first pattern of the pair and any of the segments of the other pattern of the pair.

6. The device (10) according to any one of the preceding claims, wherein any two of the segments (2) of the same pattern (M) are isolated from each other by an intra-pattern interval which is devoid of sensitive material.

7. The device (10) according to any one of the preceding claims, wherein each pattern (M) is constituted by N segments (2) which are disposed in the surface of the carrier (1), N being an integer comprised between 3 and 16, the values 3 and 16 being included, and wherein the respective orientations of the N segments of any one of the patterns are angularly equi-distributed.

8. The device (10) according to claim 7, wherein the segments (2) of each of the patterns (M) are disposed radially around a centre of the pattern, so as to form a regular star with N branches in the surface of the carrier (1).

9. The device (10) according to any one of the preceding claims, wherein each segment (2) has a length which is comprised between 50 µm and 40 mm, preferably comprised between 1 mm and 30 mm, and a width which is comprised between 10 µm and 500 µm, preferably comprised between 100 µm and 300µm, said length and width being measured parallel to the surface of the carrier (1).

10. The device (10) according to any one of the preceding claims, wherein the surface of the carrier (1) consists of an organic material that is thermally and electrically insulating, for example based on polyimide, and wherein the sensitive material comprises at least one compound which results from an alteration of the organic material, in particular a thermal degradation compound of the organic material.

11. The device (10) according to any one of the preceding claims, further comprising a thermal camera (11), arranged to capture infrared images of the surface of the carrier (1) while said surface of the carrier is exposed to electromagnetic radiation (R), so as to show in the captured images, parts of at least some of the segments (2) of the sensitive material with intensities which depend on respective temperature values of said parts of segments.

12. The device (10) according to claim 11, further comprising:
- a modulation system (12), which is arranged to apply a temporal modulation sequence to the electromagnetic radiation (R) to which the surface of the carrier (1) is exposed; and
- a synchronous detection system (13), which is arranged to filter the intensities captured in successive images of the surface of the carrier, in accordance with the temporal modulation sequence.

13. A method for manufacturing a device (10) suitable for revealing spatial variations in the polarisation of electromagnetic radiation (R), said device being in accordance with any one of the preceding claims, the manufacturing method comprising the following steps:
- providing a carrier (1) of which a surface consists of a thermally and electrically insulating organic material, for example a polyimide-based material; and
- heating the organic material selectively in specific areas of the surface of the carrier (1), for example by means of a laser beam which is directed into said areas, so as to locally alter said organic material to form the sensitive material, in particular by thermal degradation of the organic material, in order to constitute the segments (2) of sensitive material.
